(19) Europäisches Patentamt
European Patent Office
Office européen des brevets

(11) **EP 2 353 485 A1**

(12) **EUROPEAN PATENT APPLICATION**

(43) Date of publication:
**10.08.2011 Bulletin 2011/32**

(51) Int Cl.:
*A47L 15/42* (2006.01)   *D06F 37/30* (2006.01)
*D06F 39/04* (2006.01)   *D06F 58/28* (2006.01)

(21) Application number: **10152794.3**

(22) Date of filing: **05.02.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(71) Applicant: **WHIRLPOOL CORPORATION**
**Benton Harbor**
**Michigan 49022 (US)**

(72) Inventors:
• **Thumm-Jorge, Margret**
  **21025 Comerio (IT)**

• **Poettger, Robert**
  **21025 Comerio (IT)**

(74) Representative: **Guerci, Alessandro**
   **Whirlpool Europe S.r.l.**
   **Patent Department**
   **Viale G. Borghi 27**
   **21025 Comerio (VA) (IT)**

(54) **An improved load driving circuit for an electrical household appliance, such as a washing machine, dishwasher or drier**

(57) A load driving circuit (1) for an electric appliance, such as a washing machine, a dishwasher, a drier, an electric coffee machine, a water boiler or the like, which comprises at least a load supply circuit (3), a logic circuit (LS) for providing a monitoring activity of possible faults and a first measuring circuit arrangement (10a,10b) for providing a compensation of possible voltage tolerances of the load circuit (3) power supply voltages, during the monitoring activity of said logic circuit (LS).

Figure 2

EP 2 353 485 A1

**Description**

The present invention relates to a load driving circuit, particularly suitable to drive a heating element, a motor or any other electrical device and which is particularly suitable for a washing machine, a dishwasher, a drier, an electric coffee machine, a water boiler, or another electric appliance. More particularly, the present invention concerns a load driving circuit comprising a logic circuit for providing a monitoring activity of possible faults.

A further aspect of the present invention is related to a tolerance compensation procedure, which is used by the logic circuit for providing a compensation of the influence of possible voltage variations of power supply voltages.

Yet an additional aspect of the present invention concerns a testing procedure, which is used by the logic circuit for checking the presence of faults, said testing procedure adopting said tolerance compensation procedure for providing more accurate evaluations of the actual status of the load circuit, under certain circuit conditions.

In modem electric household appliances, load driving circuits are for instance applied to drive heating elements, for warming up water or air during the operative cycle of the appliance, or to drive motors or coils. As for heating circuits, they generally comprise a heating resistor and a safety circuit associated thereto, said safety circuit being aimed at preventing overheating and electric current leakage, if a fault occurs.

A first example of a load driving circuit used to drive an electric heating element is disclosed in DE-1908464. This heating circuit comprises a safety circuit, which includes a temperature regulator and a temperature limiter. A series connection, which respectively comprises the temperature regulator, a first contact switch, an electric load consisting of a heating resistor, a second contact switch and the temperature limiter, is described. The contact switches disconnect one or both junctions of the electric load when temperature sensed by the regulator overcomes a certain threshold level.

It has been seen that this load driving circuit does not provide a satisfactory level of safety, given the fact that the temperature regulator and the temperature limiter have a relatively high response time. In addition, no monitoring activity of possible faults is provided, which may cause a temperature increase.

Another example of a load driving circuit applied to an electric heater is shown in DE-19515902. This load driving circuit comprises a safety circuit, which is not provided with temperature regulators or limiters. A control arrangement activates the heating circuit after a certain predefined time has passed in the washing phase, when the water has already been supplied to the appliance.

Moreover in this circuit no monitoring activity of potential faults, such as short circuits or switch disconnections, is performed.

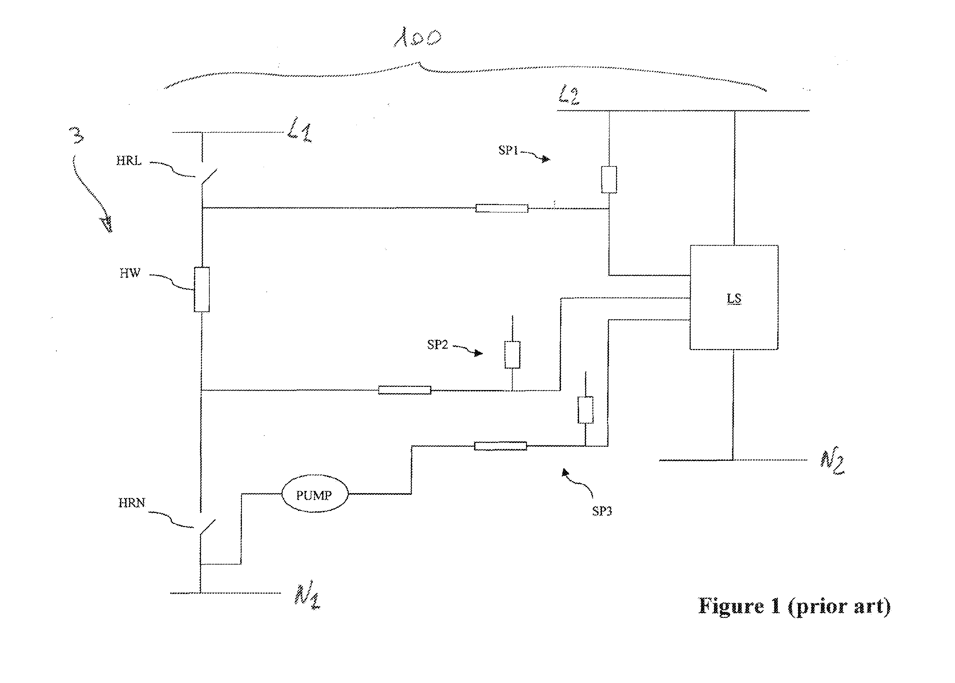

European patent application EP0924331A2 discloses a load driving circuit applied to a heater which allows overcoming the most important drawbacks of the previously described heating circuits of the prior art. The load circuit 100, which is shown in attached figure 1, comprises a load (electric heater) series connection comprising a first switch contact HRL, a heating resistor HW, which can easily be replaced with a different kind of electric load, and a second switch contact HRN. The load series connection is connected to a safety circuit, which comprises a logic circuit LS for providing a monitoring activity of possible faults of the load circuit. It is also provided a pick-up resistive circuit SP1, SP2, SP3 for connecting an input junction of the logic circuit with at least one of the junctions of the load series connection. The logic circuit, which preferably comprises a microprocessor, can check the status of the load circuit as long as the load circuit is switched off, for instance, in the case of a heating circuit, before and after the heating or the drum-spinning process. The monitoring activity is performed through a series of measurements of the potentials at the junctions of the load series connections. Such potentials are provided in input to the logic circuit through the mentioned pick-up resistive circuit. In this manner, the actual status of the main components of the load circuit can be monitored and the presence of faults such as short circuits or contact disconnections can be detected. This allows obtaining high levels of safety and reliability in the protective function that is exerted by the safety circuit.

Even if this load driving circuit represents a considerable improvement with respect to the known prior art load driving circuits, some drawbacks are still present.

A first drawback basically arises from the fact the load circuit and the logic circuit, which are typically fed respectively by the mains network and an AC/DC converter, are often subjected to power supply voltage variations. These voltage variations may be of +/- 30% of the nominal voltage (240V, 230V, 120V) for the mains network and of +/- 10% of the nominal voltage (5V) for the AC/DC converter.

It has been seen that the calculations/measurements performed by the logic circuit during the monitoring activity are influenced by the voltage tolerances of the power supply voltages provided to the load circuit and to the logic circuit. This fact may determine errors or inaccuracies, which may decrease the safety and reliability of the fault monitoring function. Unfortunately, these voltage variations are quite difficult to predict, since they can happen almost instantaneously. Moreover, the absolute amount of these voltage variations changes significantly for the load circuit and the logic circuit.

In the attempt of overcoming this problem, narrower tolerances for the variations of the nominal power supply voltage might be forced. This solution would entail the use of additional and expensive hardware for its practical implementation, which would bring to a remarkable increase of the complexity and of the manufacturing costs of the load driving circuit. In addition, this kind of approach would significantly worsen the versatility of use of the load driving circuit in the field of appliances. For example, it might be necessarily to customize the load driving circuit, depending on the nominal voltage provided by the mains network, to which the appliance is connected.

Another drawback resides in the fact that the logic circuit, during its monitoring activity, often calculates the actual equivalent resistance to ground, so it has to check whether short circuits are present. This calculation is now performed using the pick-up resistive circuit as a resistive measuring circuit. It has been proven that also this fact may bring to errors and inaccuracies in the fault monitoring function, particularly when faults are located in series to one of the resistors of the pick-up resistive circuit or in series to the electric load, in particular a resistive load such as a heating resistor or the like.

Thus, the main aim of the present invention is to provide a load driving circuit particularly suitable for an electric household appliance, such as a washing machine, a dishwasher or a drier, which allows overcoming the above mentioned drawbacks.

Within this aim, it is an object of the present invention to provide a load driving circuit, in which the monitoring activity of the logic circuit is substantially independent from possible voltage variations of the power supply voltages of the load circuit.

It is another object of the present invention to provide a load driving circuit, in which the monitoring activity of the logic circuit is substantially independent from the actual nominal power supply voltage and from the tolerances thereof.

It is also an object of the present invention to provide a load driving circuit that is quite easy to manufacture at industrial level, at relatively low costs.

Thus, the present invention provides a load driving circuit, according to appended claims .

The load driving circuit according to the present invention, comprises a first measuring circuit arrangement, which enables the logic circuit to monitor the status of the load circuit without being influenced by the power supply voltage tolerances. The logic circuit can, in fact, execute a tolerance compensation procedure, which allows compensating the voltage variations of the nominal power supply voltages, whatever being the actual amount of such variations.

In a preferred embodiment of the invention, the load driving circuit comprises a second measuring circuit arrangement, which allows the logic circuit to perform more reliable calculations for monitoring the status of the load circuit and checking the presence of faults. The logic circuit can in fact execute an improved procedure for checking the presence of faults, with more accurate calculations of the actual equivalent resistance to ground under certain circuit conditions. To this aim, the mentioned tolerance compensation procedure is used, in case of need. Therefore, the logic circuit can improve the overall quality of its monitoring activity, with higher levels of safety and reliability.

Further features and advantages of the load driving circuit, according to the present invention, will become apparent from the following description of preferred embodiments, with reference to the appended drawings, in which:

- Fig. 1 is a schematic diagram of a load driving circuit of prior art;
- Fig. 2 is a generic schematic diagram of an example of the load driving circuit, according to the present invention;
- Fig. 3a and 3b are schematic diagrams of the preferred first measuring circuit arrangement in the first and in the second connection mode, of the load driving circuit shown figure 2;
- Fig. 4a and 4b are schematic diagrams of the preferred second measuring circuit arrangement in the first and in the second connection mode, of the load driving circuit shown figure 2; and
- Fig. 5a and 5b are the equivalent electric schematics of the second measuring circuit arrangement 20a and 20b shown in figures 4a and 4b in the first and in the second calculation procedure of the first testing configuration;

Referring now to the cited figures, the present invention relates to a load driving circuit 1 for an electric household appliance, such as a washing machine, a dishwasher or a drier. By way of a no limiting example, the load driving circuit according to the present invention is hereafter described to drive an electric heater HW.

As in the prior art heating circuit 100 (figure 1) that is disclosed in the European patent application EP0924331A2, the load driving circuit 1 according to the present invention comprises a load series connection 3, in this case a heating series connection 3, which is formed at least by a first switch contact HRL, an electric load consisting in the heating resistor HW and optionally a second switch contact HRN. Upstream or downstream the heating resistor HW, fuse/s and/or thermostat/s (not shown) may be inserted for the purpose of providing additional safety.

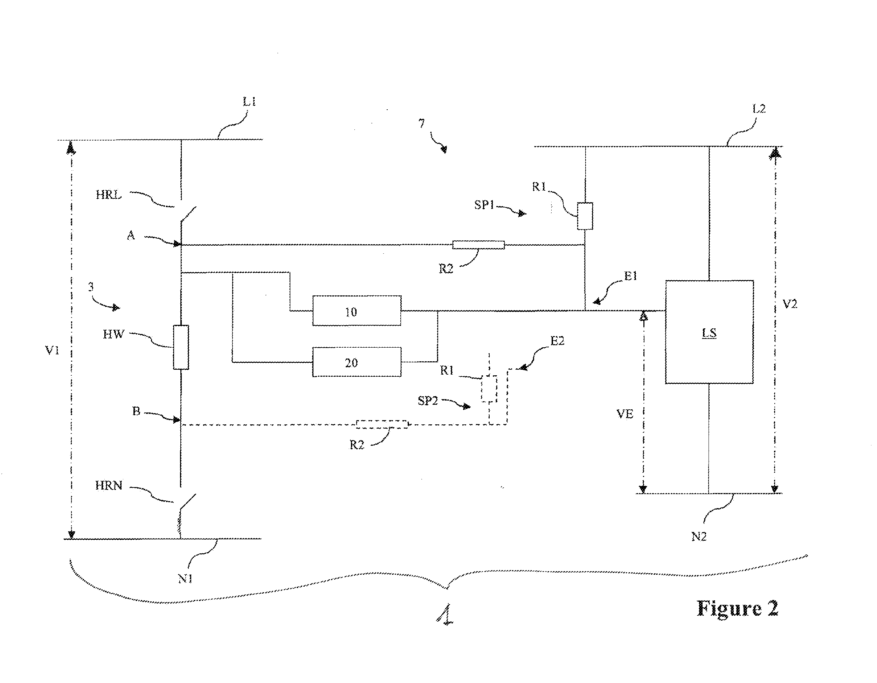

As shown starting from figure 2, a first power supply line L1, N1 supplies the mentioned load series connection 3 with a first power supply voltage V1. The first AC power supply voltage V1 may be around 120V, 230V or 240V, depending on the adopted mains network. The circuit 1 comprises a safety circuit 7 that includes at least a logic circuit LS, which preferably includes a microprocessor. The logic circuit LS provides a monitoring activity aimed at sensing possible faults in the load circuit 3. The safety circuit 7 comprises at least a pick-up resistive circuit SP1, SP2, which connects an input junction E1, E2 of the logic circuit LS with at least a junction A, B of the load series connection 3. The logic circuit LS is supplied with a second power supply voltage V2 provided by a second power supply line L2, N2. The second supply voltage V2 is advantageously provided by an AC/DC converter, so that it may be around 5V or 12V.

The peculiarity of the load driving circuit 1, according to the present invention, consists in that it comprises a first measuring circuit arrangement 10a or 10b in a complementary configuration, for providing a compensation of the voltage tolerances of the first power supply voltage V1 and/or of the second power supply voltage V2, during the monitoring activity of the logic circuit LS. In practice, as will be seen better in the following, the first measuring circuit arrangement 10a or 10b allows the logic circuit LS to compensate the intrinsic variations (also around +/- 30% with respect to the nominal value, as mentioned before) of the power supply voltages V1, V2, while performing the calculations that are needed for the exploitation of its fault monitoring activity.

From figure 2 it comes out that there are at two possible advantageous modes to connect together the two power supply lines L1 N1 and L2 N2.

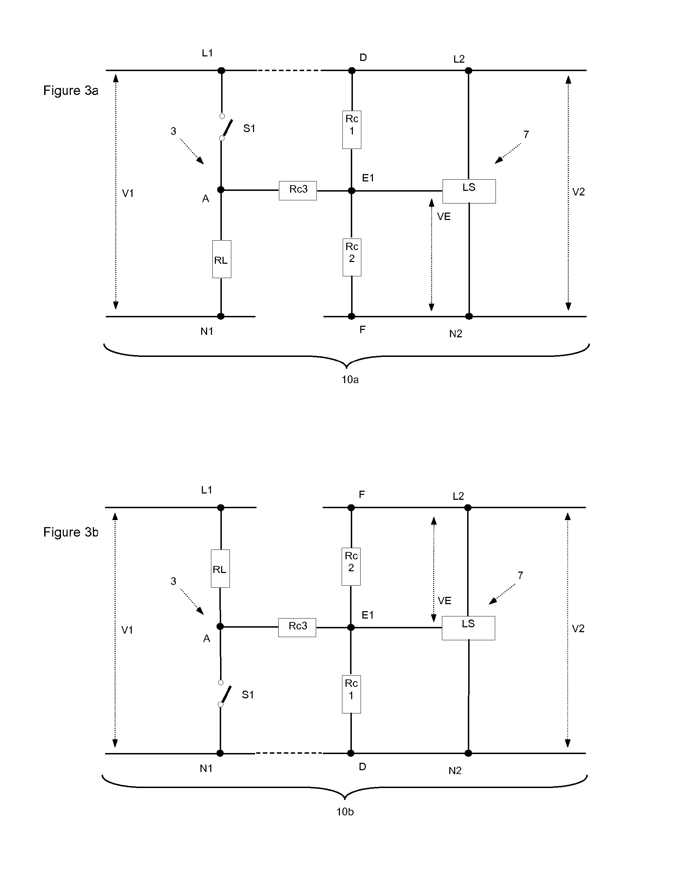

In a first connection mode, to which figures 3a, 4a and 5a are referred, first conductors L1 and L2 are connected together, while the related second conductors N1 and N2 are left independent.

In the second connection mode, to which figures 3b, 4b and 5b are referred, second conductors N1 and N2 are connected together, while the related first conductors L1 and L2 are left independent.

In figures 3a and 3b, show a preferred embodiment of the first measuring circuit arrangement 10a, in the first connection mode. For a simplified representation, only junction A of the load series connection 3 circuit has been represented in the following. However, the same circuit can be applied to other junctions of the load series connection 3, for instance junction B. In the same manner, only input junction E1 has been represented, even if a different input junction (for instance E2) of the logic circuit LS can be used.

The first measuring circuit arrangement 10a comprises preferably a star circuit arrangement, which is connected between the conductors of the second power supply line L2 N2 and a junction A (or B) of the load series connection 3. Such a star circuit arrangement comprises a first measuring resistor RC1, which is connected between a first junction D of a first conductor L2 of the second power supply line L2, N2 and an input junction E1 of the logic circuit LS. A second measuring resistor RC2 is preferably connected between a second junction F of the second conductor N2 of the second power supply line L2, N2 and said input junction E1 of the logic circuit LS, while a third measuring resistor RC3 is preferably connected between said input junction E1 and a junction A of the load series connection 3. The first measuring circuit arrangement 10a is also arranged/integrated in the load circuit 1 according to a preferred layout, which provides for a switch S1 connected between the first conductor L1 of the first power supply line L1, N1 and the junction A, to which the third resistor RC3 is connected. According to the preferred layout, a load RL is connected between the second conductor N1 of the first power supply line L1, N1 and the junction A, B, to which the third resistor RC3 is connected.

Preferably, in the first connection mode the switch S1 shown in figure 3a corresponds to the first switch contact HRL shown in figure 2 and the load RL corresponds to heating resistor HW of the same figure. That means that the third measuring resistor RC3 is preferably connected respectively to the junction A of the load circuit 1.

In figure 3b is represented the preferred embodiment of the first measuring circuit arrangement 10b in the second connection mode.

In this configuration, the first measuring circuit arrangement 10b comprises preferably a star circuit arrangement connected between the conductors of the second power supply line L2 N2 and a junction A of the load series connection 3. In such a star circuit arrangement a first measuring resistor RC1 is connected between a first junction D of a second conductor N2 of the second power supply line L2, N2, and an input junction, for instance E1 (but can also be E2) of the logic circuit LS. The second measuring resistor RC2 is preferably connected between a second junction F of the first conductor L2 of the second power supply line L2, N2 and said input junction E1 of the logic circuit LS, while the third measuring resistor RC3 is preferably connected between said input junction E1, and a junction A (or B) of the load series connection 3. The first measuring circuit arrangement 10b is also arranged/integrated in the load circuit 1, according to the preferred layout which provides for a switch S1 that is connected between the second conductor N1 of the first power supply line L1, N1 and the junction A, to which the third resistor RC3 is connected. According to the preferred layout load RL is connected between the first conductor L1 of the first power supply line L1, N1 and the junction A (or B), to which the third resistor RC3 is connected.

In both the circuits 10a and 10b, the measuring resistors RC1, RC2, RC3 can be also integrated into the pick-up resistive circuit SP1 and/or SP2 shown in figure 2, and in particular having resistors R1, R2 in common.

Moreover, in both the circuits 10a and 10b the load RL can additionally represent an additional active component P of the heating circuit 1, for example a pump or another actuator. Whenever the switch S1 is kept in the open configuration (as in the measuring configurations of Fig.3a and 3b ), these two loads represented as RL can further considered as integral with the measuring resistor RC3 and defining one single component. In fact, in this case we notice that RL, which is the equivalent of the heating resistor and of active load, can be considered as almost equals to 0 Ohm, or at least neglettable in comparison of RC3, which is for instance in the range of hundreds of k-Ohms. Junction A can be therefore considered connected directly to N1 in circuit 10a, or directly to L1 in circuit 10b.

We notice also that in some embodiments switch S1 can also be not present. In such cases the circuit 10a or 10b remains in an equivalent condition of open switch S1. However, it is in general useful to have S1 in order to be able to detect failures of the load RL through the same microcontroller connection, and by using RC1, RC2 and RC3.

All these solutions are quite advantageous since no additional hardware is required for the physical implementation of the first measuring circuit arrangement 10a and 10b.

Using the first measuring circuit arrangement 10a or 10b the logic circuit LS can preferably execute a tolerance compensation procedure for providing a compensation of the influence of possible voltage variations of the power supply voltages V1, V2. Such a tolerance compensation procedure can be advantageously used in any calculations that are performed by the logic circuit LS, during its monitoring activity. For example, as it is shown in the following, the tolerance compensation procedure can be used while executing a testing procedure for checking the presence of faults in the load circuit 1.

For illustrating the details of the tolerance compensation procedure, specific reference is made hereinafter to the embodiment of the first measuring circuit arrangement, shown in figures 3a and 3b.

The tolerance compensation procedure comprises advantageously an initial step of measuring the first power supply voltage V1, the second power supply voltage V2 and an input voltage VE at the input junction E1. The logic circuit LS can then perform a step of calculating a compensated ratio V1/V2 between the first power supply voltage V1 and the second power supply voltage V2. The compensated ratio V1/V2 can be calculated by performing a Kirchoff's current balancing at the junction E1, at which the voltage VE is measured.

The following equation (i) results from such a current balancing:

$$\frac{V2 - VE}{RC1} = \frac{VE}{RC2} + \frac{V1 - (V2 - VE)}{RC3} \tag{i}$$

The first compensated ratio V1/V2 can then be expressed according to the following equation (ii):

$$\frac{V1}{V2} = 1 + \frac{RC3}{RC1} - \left(1 + \frac{RC3}{RC1} + \frac{RC3}{RC2}\right) * \frac{VE}{V2} = K1 + K2 * \frac{VE}{V2} \tag{ii}$$

Thus, the first compensated ratio V1/V2 can be expressed as a the sum of a first parameter K1 with another parameter resulting from the multiplication of a proportional factor K2 for a ratio VE/V2 between the input voltage VE and the second power supply voltage V2. Such a first parameter K1 and such proportional factor K2 are calculated as a function of the values of the known resistors RC1, RC2, RC3 of the first measuring circuit arrangement 10a or 10b. It results that the compensated ratio V1/V2 depends on the measured input voltage ratio VE/V2 and on the values of the resistors RC1, RC2, RC3 only, whatever being the variations of the power supply voltages V1 and V2.

Thus, they are substantially independent from the single voltage tolerances of the power supply voltages V1, V2. The compensated ratio V1/V2 can then be used as compensated reference value in any calculation performed by the logic circuit LS. It should be noticed that the calculated compensated ratios are substantially independent also from the actual nominal value of the power supply voltages V1, V2. That means that the mains voltage (e.g. a 120V or a 230V mains) or the output voltage of the used AC/DC converter (e.g. proving a 5V or a 12V supply voltage) have no substantial influence on the monitoring activity of the logic circuit LS. This feature apparently enhances the versatility of use of the load driving circuit 1, which can be used in appliances working at different mains voltages, and it allows a full standardisation of its manufacture.

The same type of relationship can be derived and applied in a similar manner to the equivalent embodiment described in figure 3b.

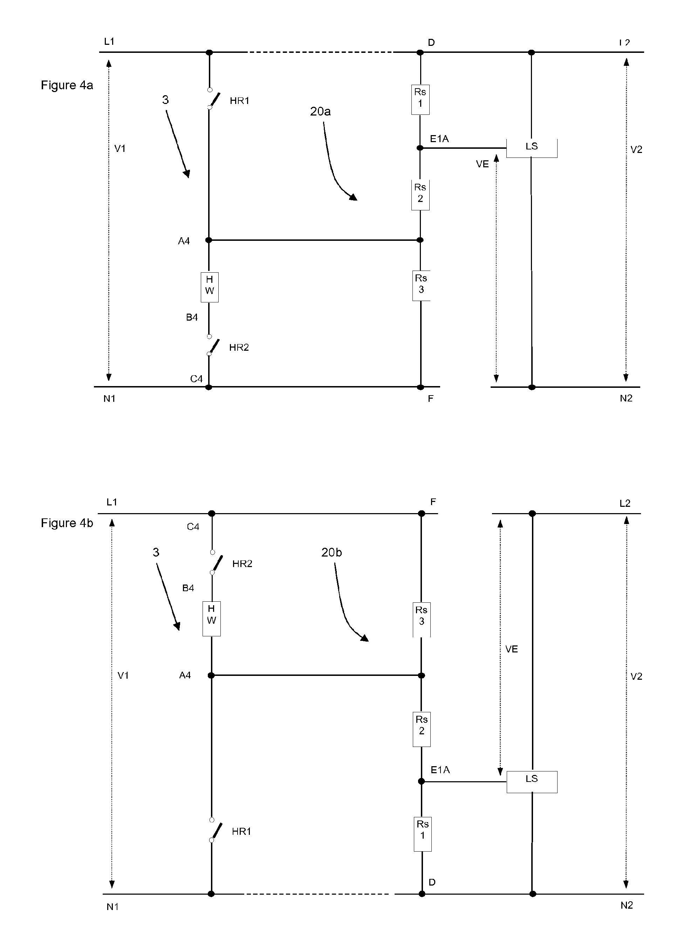

In a preferred embodiment, the load driving circuit 1, according to the present invention, comprises also a second measuring circuit arrangement 20a or 20b, to which figures 4a, 4b are referred, and which is used by the logic circuit LS for checking the presence of faults in the load circuit, in the described example an electrical heater.

In fig.4a is shown the second measuring circuit arrangement 20a in the first connection mode. For a simplified representation, only junction A of the load series connection 3 circuit has been described in the following. However, the same circuit can be applied to other junctions of the load series connection 3, for instance junction B. In the same manner, only input junction E1A has been represented, even if a different input junction of the logic circuit LS can be used.

The arrangement 20a comprises preferably a bridge circuit arrangement of three measuring resistors RS1, RS2, RS3, which are advantageously arranged according to a preferred layout that allows optimising the monitoring activity of the logic circuit LS. Particularly, a fourth measuring resistor RS1 is preferably connected between the first junction D of the first conductor L1 of the first power supply line L1, N1 and the input junctions E1A, of the logic circuit LS. A fifth measuring resistor RS3 is preferably positioned between the second junction F of the second conductor N2 of the first power supply line L1, N1 and a junction A of the load series connection 3. A sixth measuring resistor RS2 is preferably arranged between one input junctions E1 of the logic circuit LS and a junction A of the load series connection 3. In the preferred embodiment of figure 4a, the second measuring circuit arrangement 20a is arranged in an upstream position with respect to the electric load (the heating resistor HW). Thus, the measuring resistors RS1, RS2, RS3 are preferably positioned between the conductors of the first power supply line L1, N1, the input junction E1 of the logic circuit LS and the junction A (or in a similar manner to junction B) of the load circuit 1. In fig.4b it is shown the equivalent configuration of the second measuring circuit arrangement 20b in the second connection mode. The arrangement 20b comprises preferably a bridge circuit arrangement of three measuring resistors RS1, RS2, RS3, which are also arranged according to a preferred layout that allows optimising the monitoring activity of the logic circuit LS. In the equivalent arrangement 20b, the fourth measuring resistor RS1 is preferably connected between the first junction D of the second conductor N1 of the first power supply line L1, N1 and the input junctions E1A of the logic circuit LS. The fifth measuring resistor RS3 is preferably positioned between the second junction F of the first conductor L1 of the first power supply line L1, N1 and a junction A of the load series connection 3. The sixth measuring resistor RS2 is preferably arranged between one of the input junction E1m of the logic circuit LS and a junction A of the load series connection 3. In the preferred equivalent embodiment of figure 4b, the second measuring circuit arrangement 20b is arranged in a downstream position with respect to the electric load (the heating resistor HW). Thus, the measuring resistors RS1, RS2, RS3 are preferably positioned between the conductors of the first power supply line L1, N1, the input junction E1A of the logic circuit LS and the junction A of the load circuit 1.

Advantageously, also the resistors RS1, RS2, RS3 are integrated, at least partially, with the resistors R1, R2 of one of the pick-up resistive circuits SP1, SP2, SP3. Thus, no additional hardware is needed for the practical implementation of the second measuring circuit arrangement 20a and 20b.

The second measuring circuit arrangement 20a or 20b is particularly useful since it is used by the logic circuit LS for executing an improved testing procedure for checking the presence of faults. Such a testing procedure is advantageously run by the logic circuit LS before and after an operative cycle of the appliance or, better, before and after a heating cycle of the heating resistor HW.

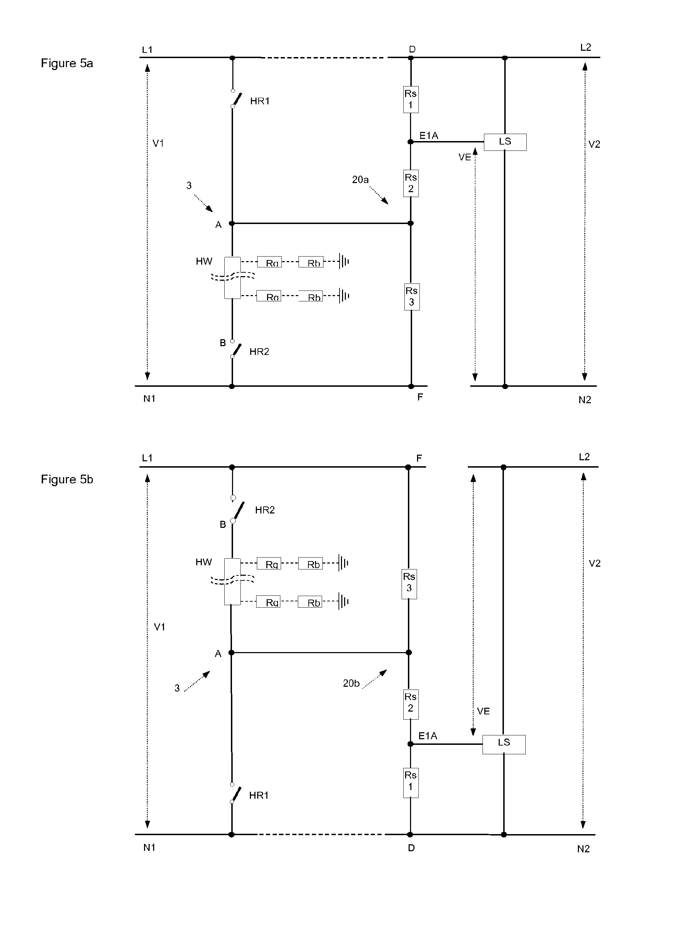

In the following, the testing procedure will be described with specific reference to the embodiment of the second measuring circuit arrangement 20a, shown in figure 4a 5a but the same results are achievable by applying a corresponding procedure to the embodiment described in figures 4b and 5b.

In general, the testing procedure comprises a plurality of steps, according to which the input voltage VE at the input junction E1A is measured, while keeping the switching contacts HR1 (corresponding to HRL of figure 2 and to S1 in figure 3a) and optionally HR2 (corresponding to HRN of figure 2) in an OFF/ON, according to certain predefined testing configurations. The measured input voltage signal VE is then compared with threshold voltage values that are predefined according to the needs. These predefined threshold voltage values may be selected depending on several circuit factors/ conditions, such as the mains network, the AC/DC converter, the heating resistor HW lifetime behaviour, and the like.

When the presence of short circuits is possible, a detailed calculation of the actual equivalent resistance under certain circuit conditions is performed, which advantageously adopts also the tolerance compensation procedure described above. At last, these comparison/calculation procedures provide results that may be indicative of the presence and type of possible faults. When a fault is signalled, the logic circuit LS activates standard failure routines, which interrupt the operative working cycle of the appliance, fully or partially, and which provide the user with alarms.

In the following, the testing procedure will be described in more detail, always referring to the embodiment of the second measuring circuit arrangement of figure 4a, even if the same testing procedure can be applied in a similar manner to the corresponding circuit of figure 4b. As mentioned above, the testing procedure provides for the series of testing configurations for the switching contacts HR1 and HR2, which is illustrated in the following. Each testing configuration corresponds to a certain predefined circuit condition, which is chosen, so as to allow a more reliable identification of a possible fault.

FIRST TESTING CONFIGURATION: HR1 = OFF (open); HR2 = OFF (open).

With the switching contacts in this first testing configuration, if no fault is present, no currents should flow through the heating resistor HW (the electric load) and the input voltage VE should have an amplitude that is in the range of the amplitude of the second power supply voltage V2 (similar, in most of the cases), unless the voltage partition operated by the series connection of the resistors RS1, RS2, RS3. In order to check whether these circuit conditions are present, the logic circuit LS runs a first checking procedure.

The first checking procedure comprises a series of steps for checking the input voltage signal VE at the input junction E1A and for deriving information related to the presence, the typology and the position of possible faults.

The first checking procedure comprises a first step of measuring the input voltage signal VE at the input junction E1A.

Once the input voltage signal VE is acquired, a first comparison procedure is executed. According to this first comparison procedure the measured input voltage signal VE is compared with respect to one or more first predefined voltage threshold values. In particular, the first comparison procedure signals the possible presence of a fault in case the superior peak voltage and the inferior peak voltage of VE are not higher respectively than the first voltage threshold values VTA1 and VTA2. For instance, these thresholds can depend from the two directions of the plug connection.

In fact, if both the peak values are lower than respective thresholds, the input voltage signal (VE) might indicate that a certain dispersion of current is present through the electric load, the heating resistor (HW).

In this latter case the logic circuit LS performs a first calculation procedure for calculating the equivalent resistance to ground Rg of the second measuring circuit arrangement 20a with the switching contacts HR1 and HR2 in the first testing configuration.

The first calculation procedure is aimed at checking whether there are faults at the first switching contact HR1 or at the fuses or thermostats upstream the electric load HW, or at the heating resistor HW itself. Thus, the equivalent resistance to ground Rg of the second measuring circuit arrangement 20a, in its equivalent configuration derivable from figure 5a, is calculated.

The following equation (iv) can be easily obtained for the resistance to ground Rg seen at the input E1A of the logic circuit LS:

$$Rg = \cfrac{1}{\cfrac{1}{\cfrac{RS1 * \cfrac{V1}{V2}}{1 - \cfrac{VE}{V2}} - RS1 - RS2} - \cfrac{1}{RS3}} - Rb \qquad (iv)$$

wherein Rb is the bleeding resistance of the appliance, which is mounted between the chassis and the load, the heating resistors HW. Rb is of known value, for instance Rb = 1.88M Ohm, but in some cases it can also be Rb = 0 Ohm.

The resistance to ground Rg can be expressed as a function of the first compensated ratio V1/V2, which can therefore be calculated according to the tolerance compensation procedure, illustrated above. In this manner, a more precise calculation of Rg can be provided by the logic circuit LS.

In a second comparison procedure the calculated value of Rg is then compared with a first predefined R-dispersion threshold value Rg1min. If Rg is lower than Rg1min then the logic circuit LS indicates a presence of a fault and a first failure routine is activated. In fact, a relatively small value of Rg indicates a certain flowing of current towards ground, thereby indicating the presence of a fault.

If Rg is higher than Rg1min or if the first comparison procedure does not signal the possible presence of a fault then the logic circuit LS proceeds to execute a test procedure in a second testing configuration of the switching contacts.

Differently, if the superior peak voltage and the inferior peak voltage of (VE) are higher respectively than the first voltage threshold values VTA1 and VTA2, then the logic circuit (LS) proceeds to execute a second comparison procedure wherein the measured input voltage signal VE is compared with respect to one or more second predefined voltage threshold values. In particular, the second comparison procedure signals the possible presence of a fault in case the superior peak voltage and the inferior peak voltage are not respectively higher and lower than second predefined voltage threshold values VTB1 and VTB2. Also in this case, the input voltage signal VE might indicate that a certain dispersion of current is present through the heating resistor HW. In the same manner for VTA1 and VTA2 thresholds VTB1 and VTB2 can be linked with the two possible directions of the plug connection to the power supply line.

If the second comparison procedure signals the possible presence of a fault, the logic circuit LS performs a second calculation procedure, according to which another calculation of the equivalent resistance to ground Rg is performed. The second calculation procedure is aimed at checking whether there are faults at the load (the heating resistor HW or at the thermostats or fuses) <u>downstream</u> it or at the second switching contact HR2. Thus, the equivalent resistance to ground Rg of the second measuring circuit arrangement 20a, in its equivalent configuration derivable from of figure 5a, is calculated. The following equation (v) can be easily obtained for the resistance to ground Rg:

$$Rg = \frac{(RS1 + RS2) * RS3}{\dfrac{RS1 * \dfrac{V1}{V2}}{1 - \dfrac{VE}{V2}} - RS1 - RS2 - RS3} - Rb \qquad\qquad (v)$$

Also in this case the resistance to ground Rg can be expressed as a function of the first compensated ratio V1/V2, which can therefore be calculated according to the tolerance compensation procedure, illustrated above.

The calculated value of Rg is then compared with a second predefined R-dispersion threshold value Rg2min. If Rg is lower than Rg2min then the logic circuit LS indicates a presence of a fault and a second failure routine is activated.

If during the mentioned first checking procedure, no faults are signalled, the testing procedure provides for changing the testing configuration of the switching contacts HR1 and HR2, as it follows.

SECOND TESTING CONFIGURATION: HR1 = ON (closed); HR2 = OFF (open).

With this second testing configuration of the switching contacts HR1 and HR2, if no faults are present the input signal VE should take values in the range of V2. In order to check whether this circuit condition is present, the logic circuit LS runs a second checking procedure of the input voltage signal VE at the input junction E1A.

The second checking procedure comprises an initial step of measuring the input voltage signal VE at the input junction E1A.

The second checking procedure comprises a step of performing a third comparison procedure of the input voltage signal VE at the input junction E1A with respect to one or more third predefined voltage threshold values.

In particular, the third comparison procedure signals the possible presence of a fault in case the superior and inferior peak voltages are not respectively higher than the third predefined voltage threshold values VTC1 and VTC2. Lower values of the input voltage signal VE might indicate that conduction problems are present upstream or downstream the first switching contact HR1 or that the first switching contact HR1 does not conduct correctly when it is in a closing state.

If the third comparison procedure signals the presence of a fault, the logic circuit LS activates a third failure routine.

If neither the second checking procedure signals any faults, the testing procedure provides for a further change of the testing configuration of the switching contacts HR1 and HR2, as it follows.

THIRD TESTING CONFIGURATION: HR1 = OFF (open); HR2 = ON (closed).

With this third testing configuration of the switching contacts HR1 and HR2, if no faults are present the input signal VE should have amplitude much lower than V2. In order to check whether this circuit condition is present, the logic circuit LS runs a third checking procedure of the input voltage signal VE at the input junction E1A.

The third checking procedure comprises an initial step of measuring the input voltage signal VE at the input junction E1A.

Then, the third checking procedure comprises a step of performing a fourth comparison procedure of the input voltage signal VE at the input junction E1A with respect to one or more fourth predefined voltage threshold values VTD1 and VTD2.

In particular, the fourth comparison procedure signals the possible presence of a fault in case the superior peak voltage and the inferior peak voltage are not respectively higher and lower than fourth predefined voltage threshold values VTD1 and VTD2. In fact this case conduction problems might me present upstream or downstream the electric load, the heating resistor HW, or the second switching contact HR2 does not conduct correctly when it is in a closing state. If the fourth comparison procedure signals the presence of a fault, the logic circuit LS activates a fourth failure routine.

If no faults are signalled at all, the testing procedure can be terminated. As a last step, the first heating switch contact HR1 and the second heating switch contact HR2 may be switched in an off state. Now, the appliance can safely start/continue/terminate its operative cycle.

For sake of simplicity it has been her omitted the calculation of the equivalent resistance to ground Rg for the testing procedure in the second connection mode, which would obviously drive to the same result. The man skilled in the art will have not difficulties to perform the equivalent calculations and to arrive to the same conclusions.

As a final remark, in the case when the "plug" connection between the mains network L1 N1 is reversed (as it can happens when the appliances are installed in the houses), the voltage on node A changes, and the comparison procedures may require the use of different threshold values ( including VTA1 VTA2 VTB1 VTB2 VTC1 VTC2 VTD1 VTD2) . The equivalent resistance seen on node A is given by (Rg + Rb) in parallel with RS3, instead of having (RS1 + RS2) in parallel with (Rg + Rb), as assumed for the shown calculations. In these cases different simple calculations need to be performed, but they are not shown here, even if they are obvious for the skilled artisan.

The load driving circuit 1, according to the present invention, has proven to fulfil the intended aims and objects.

The first measuring circuit arrangements 10a and 10b allow the logic circuit LS to run the tolerance compensation procedure that have been described above, thereby performing its monitoring activity substantially independently from possible voltage variations, from the actual nominal the power supply voltage and from the voltage tolerances of the power supply lines. This fact remarkably improves the versatility of use of the load driving circuit 1, which can be arranged for any kind of appliance. In addition, improvements in the monitoring activity are achieved, since calculations are quite more accurate, particularly when the equivalent resistance to ground has to be processed for fault identification.

The second measuring circuit arrangements 20a and 20b further improve the quality of the monitoring activity of the logic circuit LS, which is then able to run in a simple manner the effective and reliable testing procedure described above, in order to check the presence, the typology and the positioning of faults in the load circuit.

The use of dedicated measuring circuit arrangement provides an additional contribution to the improvement of the monitoring activity of the logic circuit LS, since it is possible to easily locate and identify faults wherever they occur, even series to the resistors of the load driving circuit 1.

As shown above, the load driving circuit 1, according to the present invention, is quite easy to manufacture at industrial level, at relatively low costs, since a full integration of the first and second measuring circuit arrangements 10a, 10b, 20a and 20b with the standard components of the load driving circuit 1 can be achieved, even without any addition of hardware.

## Claims

1. A load driving circuit (1) for an electric appliance, such as washing machine, dishwasher drier, electric coffee machine, water boiler or the like, said circuit comprising a load supply circuit (3) supplied with a first power supply voltage (V1) and a logic circuit (LS) for monitoring possible faults of said load supply circuit, said logic circuit (LS) being supplied with a second power supply voltage (V2), **characterised in that** it comprises a first measuring circuit arrangement (10a, 10b) for providing a compensation of possible voltage tolerances of said first power supply voltage (V1) and/or of said second power supply voltage (V2), during the monitoring of said logic circuit (LS).

2. A load driving circuit (1) according to claim 1, **characterised in that** the load supply circuit (3) comprises at least a first switch contact (HR1, HR2, HRL, HRN, S1) and an electric load (HW, RL) such as a resistor, in particular a heating resistor, a motor or the like.

3. A load driving circuit (1) according to claim 1 or 2, **characterised in that** it comprises a safety circuit (7), which comprises said logic circuit and at least a pick-up resistive circuit (SP1, SP2) for connecting an input junction (E1, E2) of said logic circuit (LS) with at least a junction (A, B) of said load supply circuit (3).

4. A load driving circuit (1) according to one or more of the previous claims, **characterised in that** the first power supply voltage (V1) is provided by a first power supply line (L1, N1) and the second power supply voltage (V2) is provided by a second power supply line (L2, N2) and wherein said first measuring circuit arrangement (10a, 10b) comprises:

   - a first measuring resistor (RC1), which is connected between a first junction (D) of a conductor of said second power supply line (L2, N2) and an input junction (E1, E2) of said logic circuit (LS);
   - a second measuring resistor (RC2), which is connected between a second junction (F) of a conductor of said second power supply line (L2, N2) and said input junction (E1, E2);
   - a third measuring resistor (RC3), which is connected between said input junction (E1, E2) and a junction (A, B) of said load supply circuit (3).

5. A load driving circuit (1) according to claim 4, **characterised in that** the first switch contact (HR1, HR2, HRL, HRN, S1) is connected between a conductor of said first power supply line (L1, N1) and said junction (A, B) of said load supply circuit (3).

6. A load driving circuit (1) according to claim 4 or 5, **characterised in that** the electric load (HW, RL) is connected between a conductor of said first power supply line (L1, N1) and said junction (A, B) of said load supply circuit (3) or between said junction (A, B) and another junction (B, A) of said load supply circuit (3).

7. A load driving circuit (1) according to one or more of the claims from 4 to 6, **characterised in that** at least one of said first, second and third measuring resistors (RC1, RC2, RC3) is integrated at least partially with one or more resistors (R1, R2) of said pick-up resistive circuit (SP1, SP2).

8. A load driving circuit (1) according to one or more of the preceding claims, **characterised in that** the electric load (HW, RL) comprises an active component (P).

9. A load driving circuit (1) according to one or more of the previous claims, **characterised in that** it comprises a second measuring circuit arrangement (20a, 20b), which is used by said logic circuit (LS) for checking the presence of faults in said load driving circuit (1).

10. A load driving circuit (1) according to claim 9, **characterised in that** said second measuring circuit arrangement (20a, 20b) comprises:

   - a second switch contact (HR2);
   - a fourth measuring resistor (RS1), which is connected between a first junction (D) of a conductor of said second power supply line and an input junction (E1A) of said logic circuit (LS);
   - a fifth measuring resistor (RS3), which is connected between a second junction (F) of a conductor of said second power supply line and a junction (A, B) of said load driving circuit (1).
   - a sixth measuring resistor (RS2), which is connected between said input junction (E1A) and said junction (A, B).

11. A load driving circuit (1) according to claim 10, **characterised in that** at least one of said first, second and third measuring resistors (RS1, RS2, RS3) is at least partially integrated with one or more resistors (R1, R2) of said pick-up resistive circuit (SP1, SP2).

12. A tolerance compensation procedure for providing a compensation of the influence of possible voltage variations of said first power supply voltage (V1) and/or of said second power supply (V2) in a load driving circuit (1), according to one or more of the previous claims, **characterised in that** it comprises two or more of the following steps:

   - measuring said first power supply voltage (V1), said second power supply voltage (V2) and an input voltage (VE) at an input junction (E1, E2) of said logic circuit (LS);
   - calculating a first compensated ratio (V1/V2) between said first power supply voltage (V1) and said second power supply voltage (V2), said compensated ratio (V1/V2) being equal to a first proportional factor (K1) added to a second proportional factor (K2) multiplied for a ratio (VE/V2) between said input voltage (VE) and said second power supply voltage (V2), said proportional factors (K1, K2) being calculated as a function of the values of the resistors (RC1, RC2, RC3) of the first measuring circuit arrangement (10a, 10b); and/or
   - calculating a second compensated ratio (V2/V1) between said second power supply voltage (V2) and said first power supply voltage (V1), said second compensated ratio (V2/V1) being equal to a first proportional factor (K1) added to a second proportional factor (K2) multiplied for a ratio (VE/V2) between said input voltage (VE) and said first power supply voltage (V2), said proportional factors (K1, K2) being calculated as a function of the values of the resistors (RC1, RC2, RC3) of the first measuring circuit arrangement (10a, 10b).

13. A testing procedure for checking the presence of faults in a load driving circuit (1), according to one or more of the claims from 1 to 11, **characterised in that** it comprises one or more of the following steps:

   - switching said first switch contact (HR1) and said second switch contact (HR2) in an OFF state;
   - performing a first checking procedure of an input voltage signal (VE) at an input junction (E1A) of said logic circuit (LS);
   - activating a first failure routine or a second failure routine, if said first checking procedure signals the presence of a fault;
   - switching said first switch contact (HR1) in an ON state and said second switch contact (HR2) in an OFF state, if said first checking procedure does not signal the presence of a fault;
   - performing a second checking procedure of said input voltage signal (VE);
   - activating a third failure routine, if said second checking procedure signals the presence of a fault;
   - switching said first switch contact (HR1) in an OFF state and said second switch contact (HR2) in an ON state, if said second checking procedure does not signal the presence of a fault;
   - performing a third checking procedure of said input voltage signal (VE);
   - activating a fourth failure routine, if said third checking procedure signals the presence of a fault.

**14.** A testing procedure, according to claim 13, **characterised in that** said first checking procedure comprises one or more of the following steps:

- measuring said input voltage signal (VE);
- performing a first comparison procedure of said input voltage signal (VE) with respect to one or more first predefined threshold values (VTA1, VTA2);
- performing a first calculation procedure of the equivalent resistance to ground (Rg) of said second measuring circuit (20a ,20b), if said first comparison procedure signals the possible presence of a fault, said first calculation procedure using a tolerance compensation procedure, according to claim 12;
- performing a second comparison procedure of said input voltage signal (VE) with respect to one or more second predefined threshold values (VTB1, VTB2), if said first comparison procedure does not signal the possible presence of a fault or if said first calculation procedure does not signal the presence of a fault;
- performing a second calculation procedure of the equivalent resistance to ground (Rg) of said second measuring circuit (20a, 20b), if said second comparison procedure signals the possible presence of a fault, said second calculation procedure using a tolerance compensation procedure, according to claim 12.

**15.** A testing procedure, according to claim 14, **characterised in that** said first calculation procedure signals the presence of a fault, if said equivalent resistance to ground (Rg) is lower than a predefined first minimum threshold level (Rg1min).

Figure 1 (prior art)

EP 2 353 485 A1

Figure 2

Figure 3a

L1    D    L2

V1    S1
3
A    Rc3    E1    LS    7    V2
RL    VE

N1    F    N2

10a

Figure 3b

L1    F    L2

V1    RL    Rc 2    VE
3    A    Rc3    E1    LS    7    V2
S1    Rc 1

N1    D    N2

10b

EP 2 353 485 A1

Figure 4a

3

20a

L1    D    L2

HR1

V1

E1A

Rs
1

Rs
2

A4

H
W

Rs
3

B4

HR2

C4

N1    F    N2

LS

VE

V2

Figure 4b

L1    F    L2

C4

3    20b

HR2

B4

H
W

V1    A4

Rs
3

Rs
2

VE

E1A    LS

HR1

Rs
1

D

N1    D    N2

V2

15

Figure 5a

Figure 5b

Europäisches
Patentamt

European
Patent Office

Office européen
des brevets

# EUROPEAN SEARCH REPORT

Application Number

EP 10 15 2794

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/008488 A1 (PEARSON STEVEN L [US] ET AL) 24 January 2002 (2002-01-24) | 1-6,8 | INV.<br>A47L15/42<br>D06F37/30<br>D06F39/04<br>D06F58/28 |
| A | * paragraphs [0001], [0002], [0006], [0009], [0014] - [0022]; claims; figure 2 * | 7,9-15 | |
| A | WO 00/31598 A1 (HOLEC HOLLAND NV [NL]; LIMON EDWARD STANLEY [NL]; SCHASFOORT PETRUS JO) 2 June 2000 (2000-06-02) * page 2, line 22 - page 3, line 30; figures * | 1-15 | |
| A | EP 2 093 581 A1 (E G O CONTROL SYSTEMS GMBH [DE]) 26 August 2009 (2009-08-26) * paragraphs [0001] - [0003], [0023] - [0031]; claims; figures * | 1-15 | |

TECHNICAL FIELDS
SEARCHED     (IPC)

A47L
D06F

The present search report has been drawn up for all claims

| Place of search | Date of completion of the search | Examiner |
|---|---|---|
| Munich | 22 July 2010 | Clivio, Eugenio |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

EP 2 353 485 A1

**ANNEX TO THE EUROPEAN SEARCH REPORT
ON EUROPEAN PATENT APPLICATION NO.**

EP 10 15 2794

This annex lists the patent family members relating to the patent documents cited in the above-mentioned European search report.
The members are as contained in the European Patent Office EDP file on
The European Patent Office is in no way liable for these particulars which are merely given for the purpose of information.

22-07-2010

| Patent document cited in search report | | Publication date | Patent family member(s) | | Publication date |
|---|---|---|---|---|---|
| US 2002008488 | A1 | 24-01-2002 | NONE | | |
| WO 0031598 | A1 | 02-06-2000 | AT | 233915 T | 15-03-2003 |
| | | | AU | 1298600 A | 13-06-2000 |
| | | | DE | 69905751 D1 | 10-04-2003 |
| | | | DE | 69905751 T2 | 19-02-2004 |
| | | | EP | 1131684 A1 | 12-09-2001 |
| | | | ES | 2192405 T3 | 01-10-2003 |
| | | | NL | 1010601 C2 | 22-05-2000 |
| EP 2093581 | A1 | 26-08-2009 | DE | 102008011495 A1 | 20-08-2009 |
| | | | US | 2009206816 A1 | 20-08-2009 |

EPO FORM P0459

For more details about this annex : see Official Journal of the European Patent Office, No. 12/82

18

**EP 2 353 485 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 1908464
- DE 19515902

- EP 0924331 A2